# EUROPEAN PATENT APPLICATION

(11) **EP 4 539 338 A1**
(43) Date of publication of application: **16.04.2025**
(21) Application number: 22945695.9
(22) Date of filing: 06.06.2022
(51) Int. Cl.: H03H 7/48

(54) **MULTIPLEXER**

(71) Applicant: NIPPON TELEGRAPH AND TELEPHONE CORPORATION, Chiyoda-ku, Tokyo 100-8116 (JP)
(72) Inventor: JO, Teruo, Musashino-shi, Tokyo 180-8585 (JP); TAKAHASHI, Hiroyuki, Musashino-shi, Tokyo 180-8585 (JP); WAKITA, Hitoshi, Musashino-shi, Tokyo 180-8585 (JP); ABDO, Ibrahim, Musashino-shi, Tokyo 180-8585 (JP)
(74) Representative: Samson & Partner Patentanwälte mbB
(86) International application number: PCT/JP2022/022768
(87) International publication number: WO 2023/238185

(57) **Abstract**

A multiplexer (1) includes an impedance converter (ZC1, ZC2). The impedance converter (ZC1) includes: a transmission line (L14) having a length of λ/4 (λ is an in-transmission-line wavelength of a signal) and a characteristic impedance of 35 Ω; and a transmission line (L15) having a length of λ/4 and a characteristic impedance of 70 Ω. The impedance converter (ZC2) includes: a transmission line (L16) having a length of λ/4 and a characteristic impedance of 35 Ω; and a transmission line (L17) having a length of λ/4 and a characteristic impedance of 70 Q.

## Description

### Technical Field

The present invention relates to a multiplexer applied to a power amplifier or the like.

### Background Art

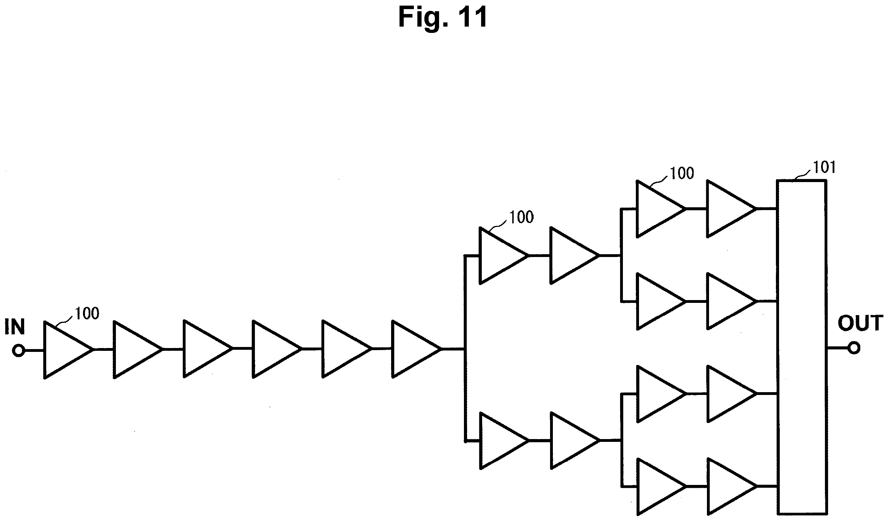

Among circuits constituting a radio communication transceiver, a power amplifier (PA) plays an important role of amplifying signal strength to a necessary level in a transmitter. In order to increase the speed and the distance of wireless communication, the PA is required to have a wide band and high output power. As a configuration of the PA that achieves high output power while maintaining a wide band, as illustrated in Fig. 11, a configuration is generally used in which unit cells 100 configured by transistors having small parasitic capacitances are parallelized and multiplexing in phase is performed by a multiplexer 101 (power combiner) after a final stage (see Non Patent Literature 1).

As a configuration of the multiplexer 101, a configuration of a Wilkinson combiner (WC) as illustrated in Fig. 12 is generally used (see Non Patent Literature 2).

However, when a conventional multiplexer is used in a high frequency PA, there is a problem in that the output power of the PA is lowered because the loss at WC is large. The cause will be described below.

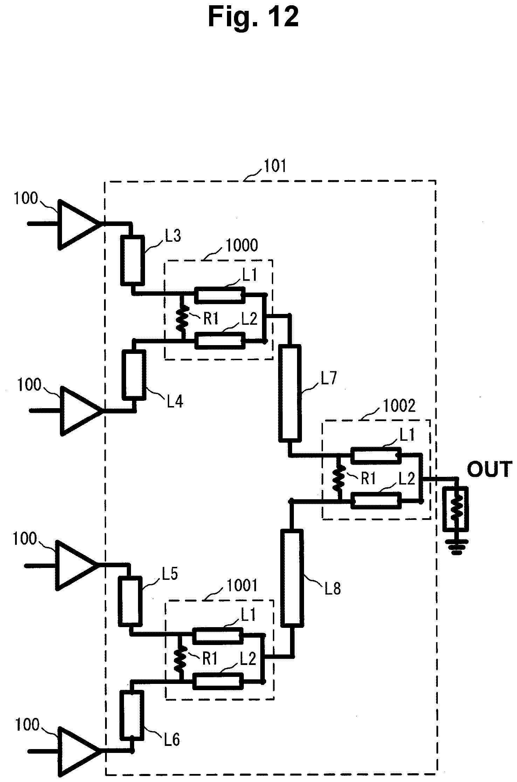

Fig. 12 illustrates a configuration of the 4:1 multiplexer 101 in a case where the final stage of the PA has a configuration in which four unit cells 100 are parallelized. In this example, 2:1 multiplexing needs to be performed twice. Therefore, it is necessary to pass through two of a WC 1000 and a WC 1002 or two of a WC 1001 and the WC 1002 between the unit cells 100 and an output OUT of the PA.

Each of the WCs 1000 to 1002 includes: two transmission lines L1 and L2, each being 70 Ω and having a length of λ/4 (λ is an in-transmission-line wavelength of a signal); and a resistor R1 of 100 Ω disposed between the transmission lines L1 and L2. In order not to degrade transmission characteristics, the resistor R1 needs to be disposed in the immediate vicinity of the two transmission lines L1 and L2. On the other hand, since the four unit cells 100 in the final stage of the PA are physically separated in a parallelization direction (vertical direction in Fig. 12), it is necessary to additionally dispose transmission lines L3 to L8 of 50 Ω extending in the vertical direction in order to multiplex the outputs of these unit cells 100. The transmission lines L1 and L2 do not contribute to the wiring in the vertical direction.
For this reason, the total length of a radio frequency (RF) line of the 4:1 multiplexer 101 becomes longer by the transmission lines of the two WCs (WC 1000 and WC 1002, or WC 1001 and WC 1002), and the loss increases.

### Citation List

### Non Patent Literature

Non Patent Literature 1: Z. Griffith, M. Urteaga, P. Rowell and R. Pierson, "A 227.5GHz InP HBT SSPA MMIC with 101mW Pout at 14.0dB Compressed Gain and 4.04% PAE", 2013 IEEE Compound Semiconductor Integrated Circuit Symposium (CSICS), 2013, pp. 1-4, doi:10.1109/CSICS.2013.6659190
Non Patent Literature 2: K. Kim and C. Nguyen, "A V-Band Power Amplifier With Integrated Wilkinson Power Dividers-Combiners and Transformers in 0.18-µm SiGe BiCMOS", in IEEE Transactions on Circuits and Systems II: Express Briefs, vol. 66, no. 3, pp. 337-341, March 2019, doi:10.1109/TCSII.2018.2850899

### Summary of Invention

### Technical Problem

The present invention has been made to solve the above problem, and an object thereof is to provide a multiplexer having a wide band and a low loss.

### Solution to Problem

A multiplexer according to the present invention includes: a first impedance converter including one end and another end, the one end of the first impedance converter being connected to a first merging point of a signal input to a first input terminal and a signal input to a second input terminal, the other end of the first impedance converter being connected to an output terminal of the multiplexer; and a second impedance converter including one end and another end, the one end of the second impedance converter being connected to a second merging point of a signal input to a third input terminal and a signal input to a fourth input terminal, the other end of the second impedance converter being connected to the output terminal, in which the first impedance converter includes: a first transmission line including one end connected to the first merging point, and having a length of λ/4 (λ is an in-transmission-line wavelength of a signal input to the first to the fourth input terminals) and a characteristic impedance of 35 Ω; and a second transmission line including one end and another end, and having a length of λ/4 and a characteristic impedance of 70 Ω, the one end of the second transmission line being connected to the other end of the first transmission line, the other end of the second transmission line being connected to the output terminal, and the second impedance converter includes: a third transmission line including one end connected to the second merging point, and having a length of λ/4 and a characteristic impedance of 35 Ω; and a fourth transmission line including one end and another end, and having a length of λ/4 and a characteristic impedance of 70 Ω, the one end of the fourth transmission line being connected to the other end of the third transmission line, the other end of the fourth transmission line being connected to the output terminal.

### Advantageous Effects of Invention

According to the present invention, the first impedance converter and the second impedance converter are provided, the first impedance converter includes a first transmission line having a length of λ/4 and a characteristic impedance of 35 Ω and a second transmission line having a length of λ/4 and a characteristic impedance of 70 Ω, and the second impedance converter includes a third transmission line having a length of λ/4 and a characteristic impedance of 35 Ω and a fourth transmission line having a length of λ/4 and a characteristic impedance of 70 Ω. As a result, the total length of an RF line is shorter than that using a conventional Wilkinson combiner, so that signals can be multiplexed in a wide band and with a low loss. As a result, when the multiplexer of the present invention is applied to a power amplifier, the output power of the power amplifier can be improved.

### Brief Description of Drawings

Fig. 1 is a circuit diagram illustrating a configuration of a 4:1 multiplexer according to a first example of the present invention.
Fig. 2 is a diagram illustrating a simulation result of a transmission loss of the 4:1 multiplexer according to the first example of the present invention.
Fig. 3 is a circuit diagram illustrating a configuration of a conventional 4:1 multiplexer.
Fig. 4 is a diagram illustrating a simulation result of a reflection loss of the 4:1 multiplexer according to the first example of the present invention.
Fig. 5 is a diagram illustrating a simulation result of isolation of the 4:1 multiplexer according to the first example of the present invention.
Fig. 6 is a plan view schematically illustrating a configuration of a 4:1 multiplexer according to a second example of the present invention.
Fig. 7 is a cross-sectional view of a transmission line of the 4:1 multiplexer according to the second example of the present invention.
Fig. 8 is a plan view schematically illustrating a configuration of a 4:1 multiplexer according to a third example of the present invention.
Figs. 9A and 9B are diagrams illustrating electric field distributions between ports in a case where there is no through silicon via and in a case where there are through silicon vias.
Fig. 10 is a diagram illustrating simulation results of the intensity of a substrate mode signal.
Fig. 11 is a block diagram illustrating a configuration of a conventional power amplifier.
Fig. 12 is a circuit diagram illustrating a configuration of a conventional 4:1 multiplexer.

### Description of Embodiments

### [First Example]

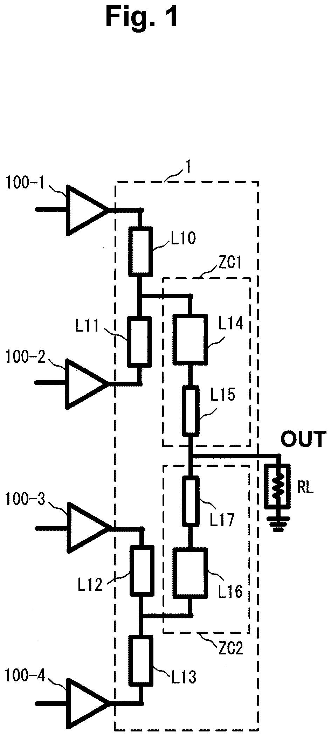

Hereinafter, examples of the present invention will be described with reference to the drawings. Fig. 1 is a circuit diagram illustrating a configuration of a 4:1 multiplexer according to a first example of the present invention. A connection form of unit cells of a PA is the same as the configuration illustrated in Fig. 11. In Fig. 1, only four unit cells 100-1 to 100-4 of a final stage of the PA are illustrated. The output impedance of each of the unit cells 100-1 to 100-4 is 50 Ω.

A 4:1 multiplexer 1 includes: a transmission line L10 including one end connected to a first input terminal (an output terminal of a first unit cell 100-1) of the multiplexer 1, and having a characteristic impedance of 50 Ω,; a transmission line L11 including one end and another end, and having a characteristic impedance of 50 Ω, the one end of the transmission line L11 being connected to a second input terminal (an output terminal of the second unit cell 100-2) of the multiplexer 1, the other end of the transmission line L11 being connected to the other end of the transmission line L10; a transmission line L12 including one end connected to a third input terminal (an output terminal of the third unit cell 100-3) of the multiplexer 1, and having a characteristic impedance of 50 Ω; a transmission line L13 including one end and another end, and having a characteristic impedance of 50 Ω, the one end of the transmission line L13 being connected to a fourth input terminal (an output terminal of the fourth unit cell 100-4) of the multiplexer 1, the other end of the transmission line L13 being connected to the other end of the transmission line L12; an impedance converter ZC1 including one end and another end, the one end of the impedance converter ZC1 being connected to a connection point (a first merging point) of the transmission lines L10 and L11, the other end of the impedance converter ZC1 being connected to an output terminal of the multiplexer 1; and an impedance converter ZC2 including one end and another end, the one end of the impedance converter ZC2 being connected to a connection point (a second merging point) of the transmission lines L12 and L13, the other end of the impedance converter ZC2 being connected to the output terminal of the multiplexer 1. RL in Fig. 1 is a load connected to the output terminal of the multiplexer 1.

The impedance converter ZC1 includes: a transmission line L14 including one end connected to the connection point of the transmission lines L10 and L11, and having a length of λ/4 (λ is an in-transmission-line wavelength of a signal input to the first to fourth input terminals) and a characteristic impedance of 35 Ω; and a transmission line L15 including one end and another end, and having a length of λ/4 and a characteristic impedance of 70 Ω, the one end of the transmission line L15 being connected to the other end of the transmission line L14, the other end of the transmission line L15 being connected to the output terminal of the multiplexer 1.

The impedance converter ZC2 includes: a transmission line L16 including one end connected to the connection point of the transmission lines L12 and L13, and having a length of λ/4 and a characteristic impedance of 35 Ω; and a transmission line L17 including one end and another end, and having a length of λ/4 and a characteristic impedance of 70 Ω, the one end of the transmission line L17 being connected to the other end of the transmission line L16, the other end of the transmission line L17 being connected to the output terminal of the multiplexer 1.

By using the 4:1 multiplexer 1 of the present example, since the total length of an RF line is shorter than that using a conventional WC, multiplexing can be performed with a low loss, and the output power of the PA can be improved.

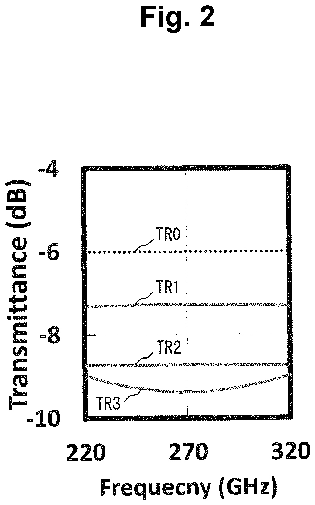

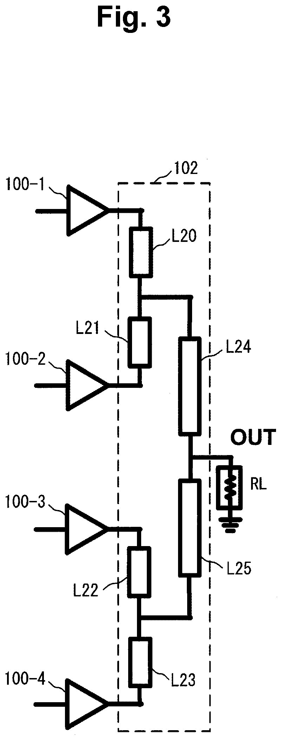

Fig. 2 illustrates a simulation result of the transmission loss of the 4:1 multiplexer 1. For comparison, simulation results of other 4:1 multiplexers are also illustrated. TR0 represents an ideal transmission loss. TR1 represents a transmission loss of the 4:1 multiplexer 1, TR2 represents a transmission loss of the conventional 4:1 multiplexer 101 illustrated in Fig. 12, and TR3 represents a transmission loss of a 4:1 multiplexer 102 illustrated in Fig. 3. The 4:1 multiplexer 102 includes transmission lines L20 to L25 having a characteristic impedance of 50 Ω.

According to Fig. 2, it can be seen that the 4:1 multiplexer 1 of the present example has the lowest loss. The reason that the 4:1 multiplexer 102 that does not use an impedance converter has a larger loss than the 4:1 multiplexer 101 has is that the reflection loss is large.

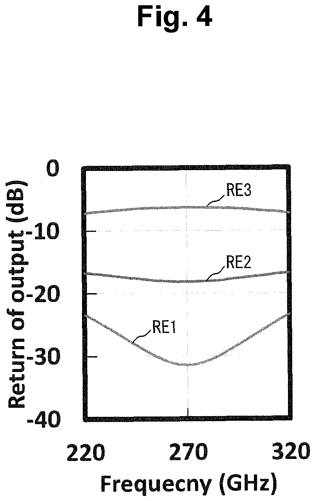

Fig. 4 illustrates simulation results of reflection losses of the 4:1 multiplexers 1, 101, and 102 as viewed from an output terminal. RE1 represents a reflection loss of the 4:1 multiplexer 1, RE2 represents a reflection loss of the 4:1 multiplexer 101, and RE3 represents a reflection loss of the 4:1 multiplexer 102. According to Fig. 4, it can be seen that a wide band and low reflection loss can be achieved by using the 4:1 multiplexer 1 of the present example.

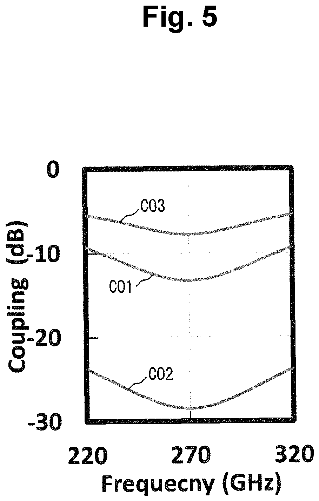

Fig. 5 illustrates simulation results of isolation between input terminals (coupling characteristics between adjacent input terminals) of the 4:1 multiplexers 1, 101, and 102. CO1 represents isolation of the 4:1 multiplexer 1, CO2 represents isolation of the 4:1 multiplexer 101, and CO3 represents isolation of the 4:1 multiplexer 102. Although the 4:1 multiplexer 1 of the present example is inferior in isolation to the 4:1 multiplexer 101, it is possible to obtain a result of better isolation than the isolation of the 4:1 multiplexer 102.

### [Second Example]

In the 4:1 multiplexer 1 described in the first example, each of the transmission lines L10 to L17 is desirably configured by a coplanar waveguide (CPW). The reason is that multiplexing can be realized with a low loss because it is hardly affected by the variation in the substrate thickness of a chip and the signal line width can be increased.

On the other hand, the ground of a transmission line at a position on the inner side in the parallelization direction (vertical direction in Fig. 1) of the unit cells tends to have a thinner and weaker pattern than the ground of a transmission line at a position on the outer side does. Therefore, there is a possibility that the impedances of the transmission lines are not the same between the outside and the inside. As a result, there is a problem in that multiplexing cannot be performed in phase and a loss increases.

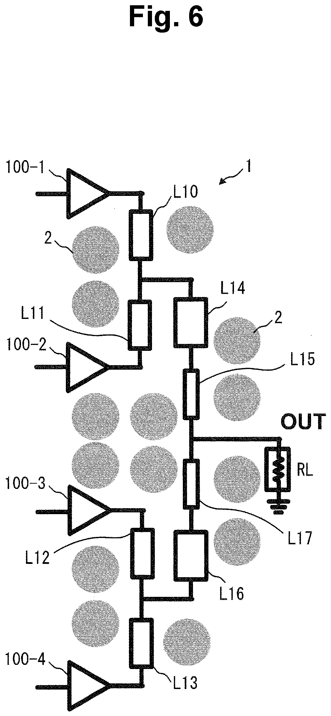

Therefore, in the present example, through silicon vias (TSV) 2 connecting a ground conductor on a chip front surface and a ground conductor on a chip back surface are densely disposed as illustrated in Fig. 6, so that the ground of a transmission line at an inner position can be strengthened, and as a result, low loss multiplexing becomes possible.

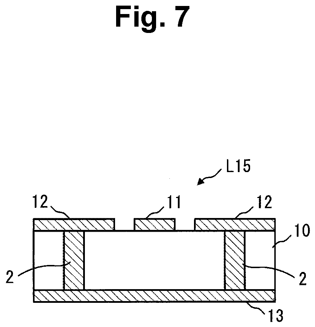

In Fig. 6, a planar configuration of the 4:1 multiplexer 1 is simply illustrated, but for example, a cross-sectional structure of the transmission line L15 is as illustrated in Fig. 7. The 4:1 multiplexer 1 is formed on a semiconductor substrate 10, the PA being formed on the same. The transmission line L15 includes: a signal line 11 formed on a front surface of the semiconductor substrate 10; ground conductors 12 formed on both outer sides, respectively, of the signal line 11 on the front surface of the semiconductor substrate 10 along a propagation direction of a signal propagating through the signal line 11; and a ground conductor 13 formed on a back surface of the semiconductor substrate 10. The TSVs 2 penetrate the semiconductor substrate 10 and are formed to connect the ground conductors 12 and the ground conductor 13.

Although Fig. 7 illustrates the transmission line L15 as an example, the configurations of the other transmission lines L10 to L14, L16, and L17 are also similar to that of the transmission line L15.

By providing a large number of TSVs 2 in the 4:1 multiplexer 1 as in the present example, it is possible to block a substrate mode signal sneaking out of the output into the input, and it is possible to obtain a secondary effect that oscillation suppression of the PA and improvement of a frequency ripple are possible.

### [Third Example]

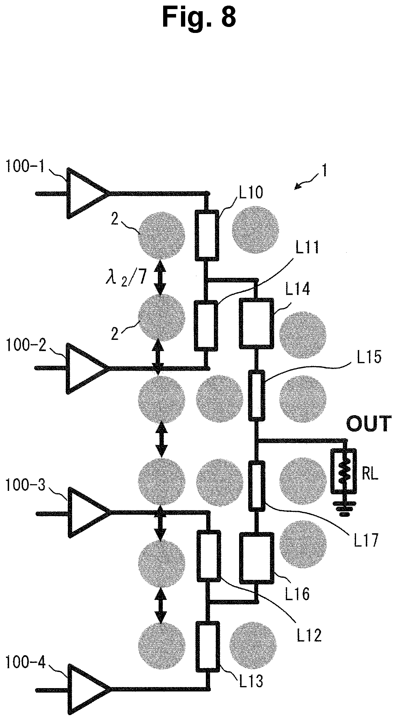

In the second example, as illustrated in Fig. 8, by setting the interval between the TSVs 2 in the plane of the semiconductor substrate 10 (the sheet surface of Fig. 8) to 1/7 or less of an in-substrate wavelength λ₂ of a signal, sneaking-in of the substrate mode signal can be remarkably suppressed. For example, when an InP substrate (dielectric constant = 12) is used as the semiconductor substrate 10, the in-substrate wavelength λ₂ of a signal of 300 GHz is 0.3 mm. Since 1/7 of the in-substrate wavelength λ₂ is 43 µm, the interval between the TSVs 2 may be 43 µm or less.

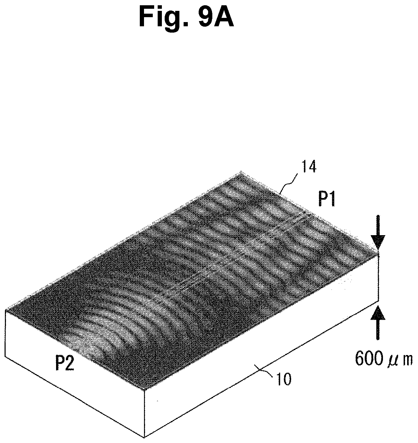

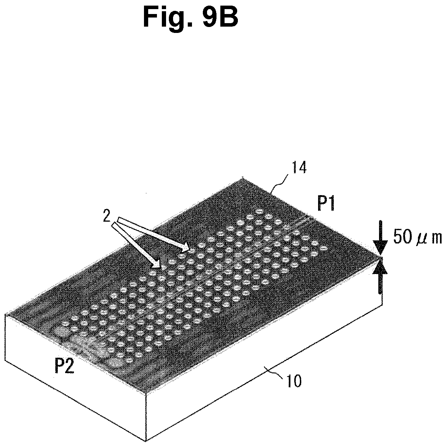

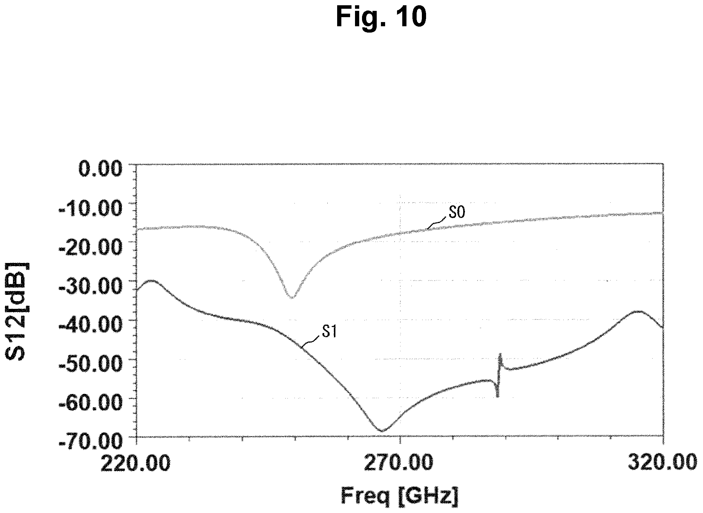

Fig. 9A is a diagram illustrating an electric field distribution between ports P1 and P2 in a case where there is no TSV 2, and Fig. 9B is a diagram illustrating an electric field distribution between the ports P1 and P2 in a case where the TSVs 2 having an interval of 40 µm are arranged. Fig. 10 is a diagram illustrating simulation results of the intensity of the substrate mode signal in the case of Figs. 9A and 9B. In the examples of Figs. 9A, 9B, and 10, the thickness of the semiconductor substrate 10 made of InP is 600 µm, and the thickness of a conductor 14 formed on the surface of the semiconductor substrate 10 is 50 µm.

In Figs. 9A and 9B, a dark portion on the surface of the semiconductor substrate 10 indicates that the electric field intensity is low, and a bright portion indicates that the electric field intensity is high. Further, S0 in Fig. 10 indicates the intensity of the substrate mode signal in a case where there is no TSV 2, and S1 indicates the intensity of the substrate mode signal in a case where the TSVs 2 are disposed. According to Figs. 9A, 9B, and 10, it can be seen that the propagation of the substrate mode signal can be greatly suppressed by arranging the TSVs 2 at an interval of 40 µm.

Some or all of the above examples may be described as the following supplementary notes, but are not limited to the following.

(Supplementary note 1) A multiplexer including: a first impedance converter including one end and another end, the one end of the first impedance converter being connected to a first merging point of a signal input to a first input terminal and a signal input to a second input terminal, the other end of the first impedance converter being connected to an output terminal of the multiplexer; and a second impedance converter including one end and another end, the one end of the second impedance converter being connected to a second merging point of a signal input to a third input terminal and a signal input to a fourth input terminal, the other end of the second impedance converter being connected to the output terminal, in which the first impedance converter includes: a first transmission line including one end connected to the first merging point, and having a length of λ/4 (λ is an in-transmission-line wavelength of a signal input to the first to the fourth input terminals) and a characteristic impedance of 35 Ω; and a second transmission line including one end and another end, and having a length of λ/4 and a characteristic impedance of 70 Ω, the one end of the second transmission line being connected to the other end of the first transmission line, the other end of the second transmission line being connected to the output terminal, and the second impedance converter includes: a third transmission line including one end connected to the second merging point, and having a length of λ/4 and a characteristic impedance of 35 Ω; and a fourth transmission line including one end and another end, and having a length of λ/4 and a characteristic impedance of 70 Ω, the one end of the fourth transmission line being connected to the other end of the third transmission line, the other end of the fourth transmission line being connected to the output terminal.

(Supplementary note 2) The multiplexer according to supplementary note 1, further including: a fifth transmission line including one end and another end, and having a characteristic impedance of 50 Ω, the one end of the fifth transmission line being connected to the first input terminal, the other end of the fifth transmission line being connected to the first merging point; a sixth transmission line including one end and another end, and having a characteristic impedance of 50 Ω, the one end of the sixth transmission line being connected to the second input terminal, the other end of the sixth transmission line being connected to the first merging point; a seventh transmission line including one end and another end, and having a characteristic impedance of 50 Ω, the one end of the seventh transmission line being connected to the third input terminal, the other end of the seventh transmission line being connected to the second merging point; and an eighth transmission line including one end and another end, and having a characteristic impedance of 50 Ω, the one end of the eighth transmission line being connected to the fourth input terminal, the other end of the eighth transmission line being connected to the second merging point.

(Supplementary note 3) The multiplexer according to supplementary note 2, in which each of the first to the eighth transmission lines includes a coplanar waveguide, each coplanar waveguide includes: a signal line formed on a surface of a substrate; a first ground conductor formed around the signal line on the surface of the substrate; and a second ground conductor formed on a back surface of the substrate, wherein the first ground conductor and the second ground conductor are connected by a through silicon via penetrating the substrate.

(Supplementary note 4) The multiplexer according to supplementary note 3, in which an interval between a plurality of the through silicon vias in a plane of the substrate is λ₂/7 (λ₂ is an in-substrate wavelength of a signal input to the first to the fourth input terminals) or less.

### Industrial Applicability

The present invention can be applied to a technique for multiplexing high frequency signals.

### Reference Signs List

1 4:1 multiplexer
2 Through silicon via
10 Semiconductor substrate
11 Signal line
12, 13 Ground conductor
100, 100-1 to 100-4 Unit cell
L10 to L17 Transmission line
ZC1, ZC2 Impedance converter

## Claims

1. A multiplexer comprising:
a first impedance converter including one end and another end, the one end of the first impedance converter being connected to a first merging point of a signal input to a first input terminal and a signal input to a second input terminal, the other end of the first impedance converter being connected to an output terminal of the multiplexer; and
a second impedance converter including one end and another end, the one end of the second impedance converter being connected to a second merging point of a signal input to a third input terminal and a signal input to a fourth input terminal, the other end of the second impedance converter being connected to the output terminal, wherein
the first impedance converter includes:
a first transmission line including one end connected to the first merging point, and having a length of λ/4 (λ is an in-transmission-line wavelength of a signal input to the first to the fourth input terminals) and a characteristic impedance of 35 Ω; and
a second transmission line including one end and another end, and having a length of λ/4 and a characteristic impedance of 70 Ω, the one end of the second transmission line being connected to the other end of the first transmission line, the other end of the second transmission line being connected to the output terminal, and
the second impedance converter includes:
a third transmission line including one end connected to the second merging point, and having a length of λ/4 and a characteristic impedance of 35 Ω; and
a fourth transmission line including one end and another end, and having a length of λ/4 and a characteristic impedance of 70 Ω, the one end of the fourth transmission line being connected to the other end of the third transmission line, the other end of the fourth transmission line being connected to the output terminal.

2. The multiplexer according to claim 1, further comprising:
a fifth transmission line including one end and another end, and having a characteristic impedance of 50 Ω, the one end of the fifth transmission line being connected to the first input terminal, the other end of the fifth transmission line being connected to the first merging point;
a sixth transmission line including one end and another end, and having a characteristic impedance of 50 Ω, the one end of the sixth transmission line being connected to the second input terminal, the other end of the sixth transmission line being connected to the first merging point;
a seventh transmission line including one end and another end, and having a characteristic impedance of 50 Ω, the one end of the seventh transmission line being connected to the third input terminal, the other end of the seventh transmission line being connected to the second merging point; and
an eighth transmission line including one end and another end, and having a characteristic impedance of 50 Ω, the one end of the eighth transmission line being connected to the fourth input terminal, the other end of the eighth transmission line being connected to the second merging point.

3. The multiplexer according to claim 2, wherein
each of the first to the eighth transmission lines includes a coplanar waveguide,
each coplanar waveguide includes:
a signal line formed on a surface of a substrate;
a first ground conductor formed around the signal line on the surface of the substrate; and
a second ground conductor formed on a back surface of the substrate,
wherein the first ground conductor and the second ground conductor are connected by a through silicon via penetrating the substrate.

4. The multiplexer according to claim 3, wherein
an interval between a plurality of the through silicon vias in a plane of the substrate is λ₂/7 (λ₂ is an in-substrate wavelength of a signal input to the first to the fourth input terminals) or less.
